# EUROPÄISCHE PATENTANMELDUNG

(11) **EP 4 012 857 A1**
(43) Veröffentlichungstag der Anmeldung: **15.06.2022**
(21) Anmeldenummer: 20213415.1
(22) Anmeldetag: 11.12.2020
(51) Int. Cl.: H02B 1/56, H05K 7/20, F28F 13/00

(54) **WÄRMETAUSCHERANORDNUNG**

(71) Anmelder: Siemens Aktiengesellschaft, 80333 München (DE)
(72) Erfinder: Pöhler, Dirk, 08141 Reinsdorf (DE)

(57) **Zusammenfassung**

Die Erfindung betrifft eine Wärmetauscheranordnung (1) zur Verlustwärme-Ableitung von elektronischen Komponenten (K) aufweisend ein Übertragungsmittel (10) ausgestaltet thermische Energie, von einem ersten Kühlmedium (M1) für die elektronischen Komponenten (K) auf ein zweites Kühlmedium (M2) zu übertragen, wobei das Übertragungsmittel (10) eine Schichtstruktur mit
einer ersten Schicht (11),
einer zweiten Schicht (12) und
einer dritten Schicht (13) aufweist, dabei ist zumindest die erste Schicht (11) aus einem Poren aufweisenden Stoff ausgestaltet, bei welchen ein Verhältnis eines Gesamtvolumens der ersten Schicht (11) zu einem durch die Poren gebildeten Hohlraumvolumen der ersten Schicht (11) derart optimiert ist, dass eine daraus resultierende Porengröße (PG) ein Optimum für eine Wärmeleitfähigkeit (L) der ersten Schicht (11) und einem Strömungswiderstand (R) für das erste Kühlmedium (M1) durch die Poren bildet.

## Beschreibung

Die Erfindung betrifft eine Wärmetauscheranordnung zur Verlustwärmeableitung von elektronischen Komponenten aufweisend ein Übertragungsmittel ausgestaltet thermische Energie von einem ersten Kühlmedium für die elektronischen Komponenten auf ein zweites Kühlmedium zu übertragen.

Im Sinne der Erfindung kann unter der Wärmetauscheranordnung auch ein Kühlkörper verstanden werden. Bei bekannten klassischen Kühlkörpern oder Wärmetauschern, beispielsweise bei Luft/Luft-Wärmetauscher, besitzen diese eine geringe Kühlleistung. Einflussfaktoren hierfür sind u.a. eine Temperaturdifferenz zwischen internen und externen Kühlrippen, ein Volumenstrom über den Kühlrippen, ein Wärmeübergangskoeffizient und eine Oberfläche, die von einem Volumenstrom erfasst wird.

Im Hinblick auf ein Preis-Leistungs-Verhältnis werden klassische Kühlkörper in der Regel aus einem Stranggussmaterial hergestellt. Eine Größe des Kühlkörpers nach der klassischen Stranggussherstellung ist aufgrund des Strangprofils/Werkzeugs vorgegeben und begrenzt.

Es ist Aufgabe der vorliegenden Erfindung eine Wärmetauscheranordnung bzw. einen Kühlkörper anzugeben, welcher zum einen nicht von einer klassischen Herstellung nach einem Stranggussverfahren abhängig ist und zum anderen bei gleichen Volumen eine höhere Kühlleistung erzielen kann.

Die eingangs genannte Aufgabe wird bei einer Wärmetauscheranordnung dadurch gelöst, dass das Übertragungsmittel eine Schichtstruktur mit einer ersten Schicht, einer zweiten Schicht und einer dritten Schicht aufweist, dabei ist zumindest die erste Schicht aus einem Poren aufweisenden Stoff ausgestaltet, bei welchen ein Verhältnis eines Gesamtvolumens der ersten Schicht zu einem durch die Poren gebildeten Hohlraumvolumen der ersten Schicht derart optimiert ist, dass eine daraus resultierende Porengröße ein Optimum für eine Wärmeleitfähigkeit der ersten Schicht und einem Strömungswiderstand für das Kühlmedium durch die Poren bildet.

Durch den Einsatz eines porösen Stoffes bei einem Wärmetauscher bzw. Kühlkörper, kann beim selben Volumen mehr Oberfläche generiert werden. Somit kann mehr Wärmeenergie aufgenommen bzw. abgegeben werden. Hier ist ein optimiertes Verhältnis dieses, welches eine maximale Fläche im definierten Volumen bei einem geringen Staudruck des angestrebten Kühlmediums abbildet. Vorteilhafter Weise ist das Ergebnis, dass deutlich mehr Energie aufgenommen bzw. abgegeben werden kann. Nach Berechnungen mit einem Extremwert- bzw. Optimierungswert-Problem kann damit gerechnet werden, dass nahezu eine verdoppelte Effektivität einer Wärmetauscheranordnung zum Kühlen hergestellt werden kann, als es bei Standard-Kühlkörpern, beispielsweise einem aus Vollmaterial, der Fall ist. Das hätte den Vorteil, dass mit einem halbierten Volumen die gleich Kühlleistung erreichen kann.

Je nach Porengröße liegt eine Wärmeleitfähigkeit des verwendeten Stoffes im Bereich von 30 bis 50 Watt pro Meter Kelvin.

Somit kann die Wärme von einem Ort, beispielsweise aus dem Inneren eines Schaltschrankes, zu einem anderen Ort, beispielsweise außerhalb des Schaltschrankes, durch eine Strömung durch die Poren des ersten zu kühlenden Mediums transportiert werden.

In einer vorteilhaften Ausgestaltung der Wärmetauscheranordnung ist die zweite Schicht aus einem Vollmaterial, welches für das erste Kühlmedium undurchlässig ist, ausgestaltet. Insbesondere bei einer Anwendung in einen Schaltschrank ist die Ausgestaltung der zweiten Schicht als ein Vollmaterial dahingehend vorteilhaft, dass das erste Kühlmedium nicht nach außen wegströmen kann bzw. eine Wärmetauscheranordnung den Raum mit den elektronischen Komponenten nach außen hin abdichtet.

Eine Wärmeübertragung bzw. Energieübertragung oder Wärmeleitfähigkeit kann bei der Wärmetauscheranordnung dadurch verbessert werden, dass die dritte Schicht ebenfalls aus einem Poren aufweisenden Stoff ausgestaltet ist, bei welchem ein Verhältnis eines Gesamtvolumens der dritten Schicht zu einem durch die Poren gebildeten Hohlraumvolumen der dritten Schicht derart optimiert ist, dass eine daraus resultierende Porengröße und ein Optimum für eine Wärmeleitfähigkeit der dritten Schicht und einem Strömungswiderstand für das zweite Kühlmedium durch die Poren bildet.

Die dritte Schicht, für den Fall, dass sie nach außen zeigt und das zweite Kühlmedium eine Umweltluft ist, kann weiterhin dahingehend porentechnisch ausgestaltet sein, dass die Poren derart groß sind, dass eine Luftverschmutzung die Poren nicht zusetzt.

Weiterhin ist es vorteilhaft, wenn die erste Schicht eine erste Rippenstruktur aufweist, welche derart angeordnet ist, dass das erste Kühlmedium eine vertikale Führung erfährt und somit eine Strömungsrichtung des ersten Kühlmediums senkrecht ist.

Weiter verbessert wird die Kühlwirkung, wenn die dritte Schicht eine zweite Rippenstruktur aufweist, die derart angeordnet ist, dass das zweite Kühlmedium eine vertikale Führung erfährt und somit eine Strömungsrichtung des zweiten Kühlmediums senkrecht ist.

Als besonders vorteilhaft für den Stoff wird poröses Aluminium angesehen. Poröses Aluminium ist für gasförmige und flüssige Medium durchlässig.

Vorteilhaft ist es, wenn der poröse Stoff derart ausgestaltet ist, dass im Wesentlichen alle Poren miteinander in Verbindung stehen und eine Porenmatrix vorhanden ist.

Eine Porengröße liegt im Bereich von 0,2 mm bis 2,0 mm. Man erreicht eine hohe Maßzahl für ein Verhältnis von innerer Oberfläche in Quadratmeter zu dem Gesamtvolumen in Kubikmetern. Beispielsweise ist bei einer Porengröße von 0,3 mm bis 0,5 mm das Verhältnis von innerer Oberfläche zu Gesamtvolumen ca. 10.000.

Im Hinblick auf die Kühlung von elektrischen Komponenten in einem Schaltschrank ist die Wärmetauscheranordnung ausgestaltet zur Integration in eine Rückwand eines Schaltschrankes. Zur Abdichtung weist die Wärmetauscheranordnung eine umlaufende Nut für eine Dichtung auf.

Zusammenfassend kann gesagt werden, dass Wärmetauscher aus porösen Aluminium, insbesondere im Aufbau mit drei Schichten, wobei eine mittlere Schicht ein Vollmaterial ist, für die Anwendung als Wärmetauscher hervorragend geeignet ist. Für die Wärmeübertragung wird aufgrund der guten Wärmeleitfähigkeit überwiegend Aluminium verwendet. Eine Wärmetauschfähigkeit von porösen Aluminium ist höher als bei herkömmlich verarbeitetem Aluminium, da poröses Aluminium im Verhältnis zum Volumen eine sehr große Oberfläche hat.

Der große Vorteil von porösen Aluminium ist seine Durchlässigkeit für Flüssigkeiten und Gase. Wenn beispielsweise eine Flüssigkeit oder ein Gas durch einen Block von porösen Aluminium strömt, dann kann dieses Gas oder diese Flüssigkeit viel mehr Wärmeenergie aufgrund einer großen Kontaktfläche aufnehmen.

Die Zeichnung zeigt ein Ausführungsbeispiel. Dabei zeigt:
- FIG 1: einen Wärmetauscher in einem Schaltschrank,
- FIG 2: den Wärmetauscher in dem Schaltschrank in der Darstellung mit getrennten Kühlmedien,
- FIG 3: einen schematischen Wärmetauscher mit Rippenstruktur,
- FIG 4: eine Porenmatrix,
- FIG 5: eine Draufsicht auf einen Wärmetauscher mit einer ersten Rippenstruktur und einer zweiten Rippenstruktur,
- FIG 6: eine Innenseite des Wärmetauschers mit Sicht auf die erste Rippenstruktur und
- FIG 7: eine Außenseite des Wärmetauschers mit Sicht auf die zweite Rippenstruktur.

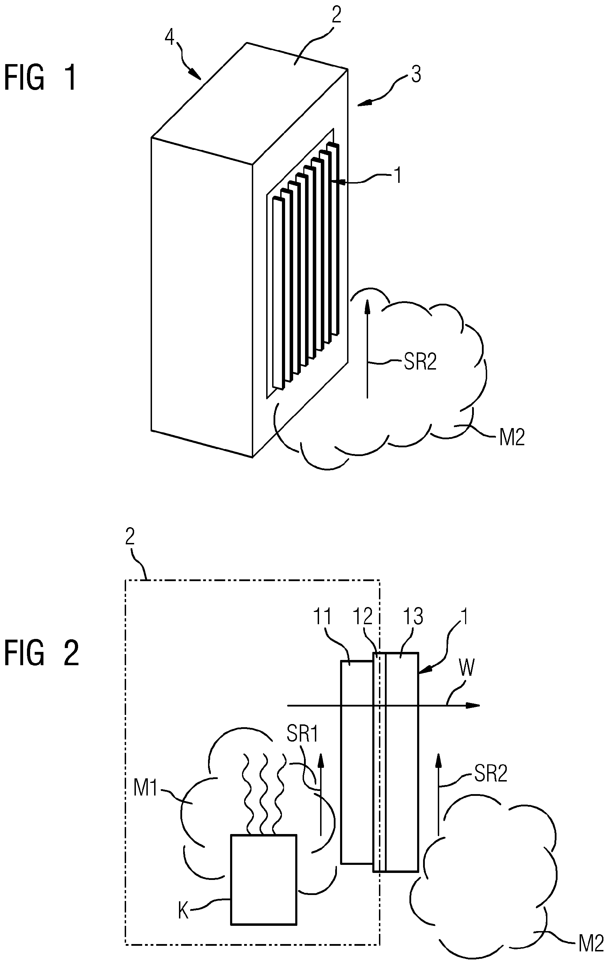

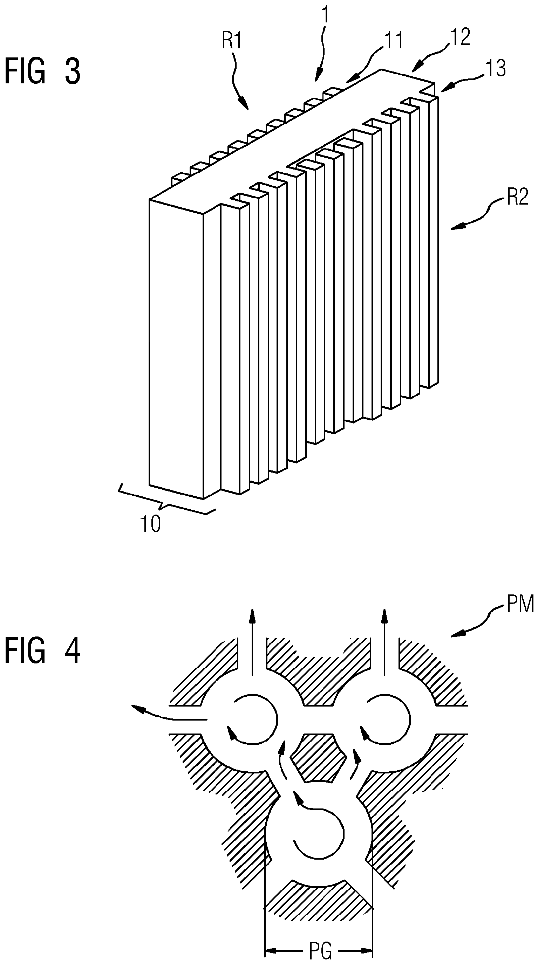

Gemäß FIG 1 ist eine Wärmetauscheranordnung 1 in einem Schaltschrank 2 integriert. Der Schaltschrank 2 weist eine Vorderseite 4 (Tür) und eine Rückseite 3 auf. Vorteilhafterweise ist der Wärmetauscher 1 in der Rückwand der Rückseite 3 des Schaltschrankes 2 integriert. Die Wärmetauscheranordnung 1 weist eine Rippenstruktur auf (siehe FIG 3), wodurch außerhalb des Schaltschrankes 2 zwischen der Rippenstruktur eine zweite Strömungsrichtung SR2 durch ein zweites Kühlmedium M2 entsteht.

Die FIG 2 zeigt schematisch die Wärmetauscheranordnung 1 in einem Schichtenaufbau. Um eine Verlustwärmeableitung von elektronischen Komponenten K innerhalb des Schaltschrankes 2 möglichst effektiv zu gestalten und die thermische Energie von einem ersten Kühlmedium M1 innerhalb des Schaltschrankes 2 nach außen zu übertragen, weist die Wärmetauscheranordnung 1 eine Schichtstruktur mit einer ersten Schicht 11, einer zweiten Schicht 12 und einer dritten Schicht 13 auf. Dabei ist zumindest die erste Schicht 11 aus einem Poren aufweisenden Stoff ausgestaltet, bei welchem ein Verhältnis eines Gesamtvolumens der ersten Schicht 11 zu einem durch die Poren gebildeten Hohlraumvolumen der ersten Schicht 11 derart optimiert ist, dass eine daraus resultierende Porengröße PG (siehe FIG 4) derart optimiert ist, dass ein Optimum für eine Wärmeleitfähigkeit L der ersten Schicht 11 und einem Strömungswiderstand R für das erste Kühlmedium M1 durch die Poren gebildet wird.

Weist die erste Schicht 11 eine erste Rippenstruktur R1 und die dritte Schicht 13 ein zweite Rippenstruktur R2 auf, so wie in FIG 3 abgebildet, so entsteht im Inneren des Schaltschrankes 2 eine erste Strömungsrichtung SR1 für das erste Kühlmedium M1 und außerhalb des Schaltschrankes 2 entsteht durch die zweite Rippenstruktur R2 eine zweite Strömungsrichtung SR2 des zweiten Kühlmediums M2.

Ein Wärmeübergang W vom Inneren des Schaltschrankes 2 nach außen wird durch die Wärmetauscheranordnung 1 realisiert.

FIG 3 zeigt schematisch die Wärmetauscheranordnung 1 mit ihren drei Schichten, wobei die erste Schicht 11 eine erste Rippenstruktur R1 aufweist, und diese Rippenstruktur aus einem porösen Aluminium ausgestaltet ist. Die zweite Schicht 12 ist aus einem Vollmaterial hergestellt, damit ein Innenraum des Schaltschrankes 2 von einem Außenraum hermetisch abgeriegelt ist. Die dritte Schicht 13 ist ebenfalls aus einem porösen Aluminium ausgestaltet, damit die Wärmeübertragung W effektiver wird. Die ganze Schichtstruktur kann auch als Übertragungsmedium 10 angesehen werden.

Gemäß FIG 4 wird eine Porenmatrix PM dargestellt. Das besondere an der Porenstruktur oder Porenmatrix PM in einem porösen Aluminium ist, dass dieser poröse Aluminiumstoff derart ausgestaltet ist, dass im Wesentlichen alle Poren miteinander in Verbindung stehen, wobei mit einer bestimmten Porengröße ein Maximum an Wärmeleitwert L und ein Minimum an Strömungswiderstand R für ein Kühlmedium erreicht werden kann.

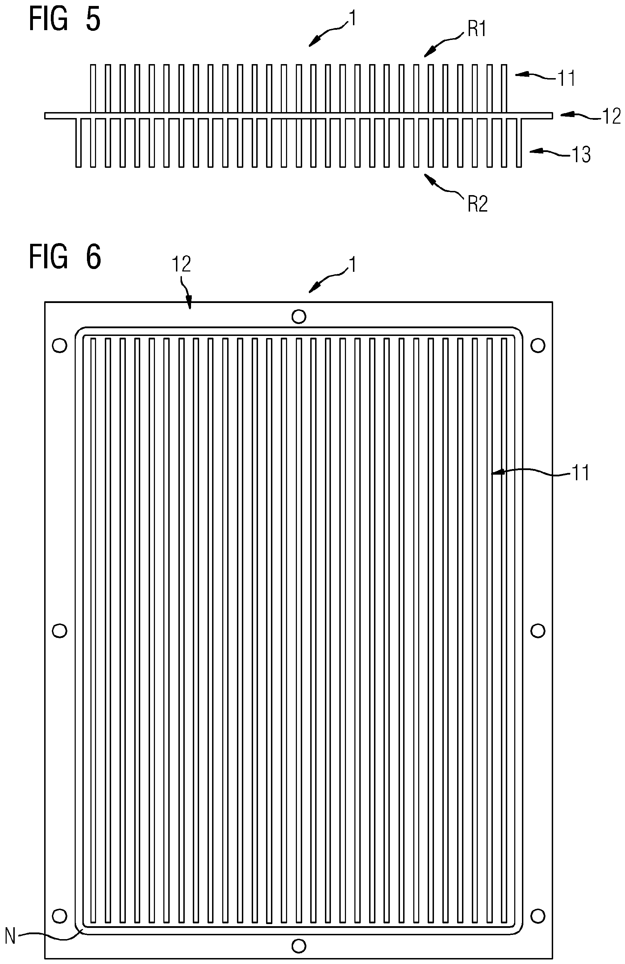

FIG 5 zeigt eine Draufsicht auf eine mögliche Ausgestaltung einer Wärmetauscheranordnung 1 mit einer ersten Rippenstruktur R1 und einer zweiten Rippenstruktur R2. Die erste Rippenstruktur R1 zeigt ins Innere des Schaltschrankes 2 und die zweite Rippenstruktur R2 zeigt nach außen. Verdeutlicht wird nochmal der dreischichtige Aufbau von der ersten Schicht 11, der zweiten Schicht 12 und der dritten Schicht 13, wobei die erste Schicht 11 durch die erste Rippenstruktur R1 gebildet ist, die zweite Schicht 12 durch ein Vollmaterial, beispielsweise eine Grundplatte, gebildet ist und die dritte Schicht 13 durch die zweite Rippenstruktur R2 gebildet ist.

Die FIG 6 zeigt die Wärmetauscheranordnung 1 in einer Sicht auf die erste Rippenstruktur R1. Um eine Abdichtung des Schaltschrankes 2 nach außen zu erreichen, weist die zweite Schicht 12 aus Vollmaterial eine umlaufende Nut N für eine Dichtung auf.

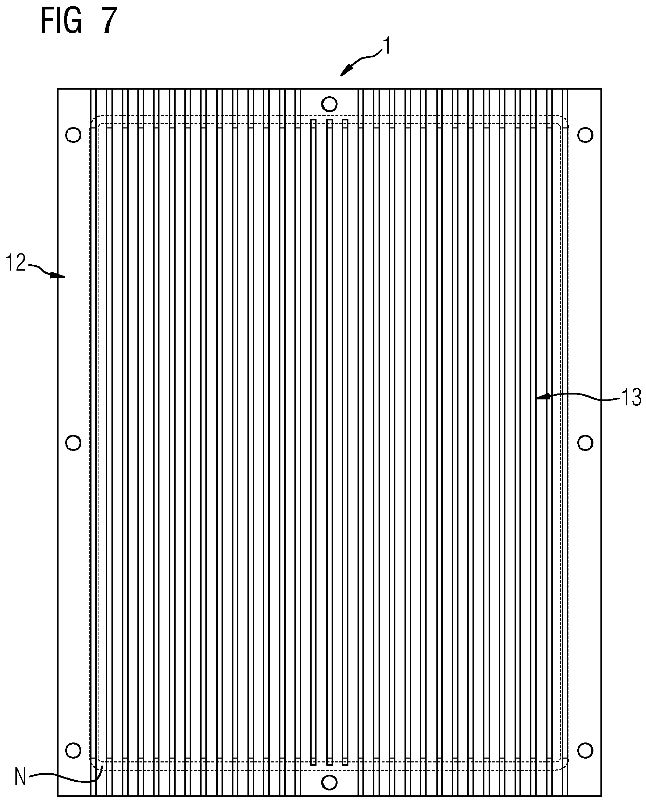

Die FIG 7 zeigt die Wärmetauscheranordnung 1 nach FIG 5 und FIG 6 in einer Sicht auf die zweite Rippenstruktur R2, also auf die Außenseite.

## Patentansprüche

1. Wärmetauscheranordnung (1) zur Verlustwärme-Ableitung von elektronischen Komponenten (K) aufweisend ein Übertragungsmittel (10) ausgestaltet thermische Energie, von einem ersten Kühlmedium (M1) für die elektronischen Komponenten (K) auf ein zweites Kühlmedium (M2) zu übertragen,
**dadurch gekennzeichnet, dass** das Übertragungsmittel (10) eine Schichtstruktur mit
einer ersten Schicht (11),
einer zweiten Schicht (12) und
einer dritten Schicht (13) aufweist, dabei ist zumindest die erste Schicht (11) aus einem Poren aufweisenden Stoff ausgestaltet, bei welchen ein Verhältnis eines Gesamtvolumens der ersten Schicht (11) zu einem durch die Poren gebildeten Hohlraumvolumen der ersten Schicht (11) derart optimiert ist, dass eine daraus resultierende Porengröße (PG) ein Optimum für eine Wärmeleitfähigkeit (L) der ersten Schicht (11) und einem Strömungswiderstand (R) für das erste Kühlmedium (M1) durch die Poren bildet.

2. Wärmetauscheranordnung (1) nach Anspruch 1, wobei die zweite Schicht (12) aus einem Vollmaterial, welches für das erste Kühlmedium (M1) undurchlässig ist, ausgestaltet ist.

3. Wärmetauscheranordnung (1) nach Anspruch 1 oder 2, wobei die dritte Schicht (13) aus einem Poren aufweisenden Stoff ausgestaltet ist, bei welchen ein Verhältnis eines Gesamtvolumens der dritten Schicht (13) zu einem durch die Poren gebildeten Hohlraumvolumen der dritten Schicht (13) derart optimiert ist, dass eine daraus resultierende Porengröße (PG) ein Optimum für eine Wärmeleitfähigkeit (L) der dritten Schicht (13) und einem Strömungswiderstand (R) für das zweite Kühlmedium (M2) durch die Poren bildet.

4. Wärmetauscheranordnung (1) nach einem der Ansprüche 1 bis 3, wobei die erste Schicht (11) eine erste Rippenstruktur (R1) aufweist, welche derart angeordnet ist, dass das erste Kühlmedium (M1) eine vertikale Führung erfährt und somit eine Strömungsrichtung (SR1) des ersten Kühlmediums (M1) senkrecht ist.

5. Wärmetauscheranordnung (1) nach einem der Ansprüche 1 bis 4, wobei die dritte Schicht (13) eine zweite Rippenstruktur (R2) aufweist, welche derart angeordnet ist, dass das zweite Kühlmedium (M2) eine vertikale Führung erfährt und somit eine Strömungsrichtung (SR2) des zweiten Kühlmediums (M2) senkrecht ist.

6. Wärmetauscheranordnung (1) nach einem der Ansprüche 1 bis 5, wobei der Stoff ein poröses Aluminium ist.

7. Wärmetauscheranordnung (1) nach einem der Ansprüche 1 bis 6, wobei der poröse Stoff derart ausgestaltet ist, dass im Wesentlichen alle Poren miteinander in Verbindung stehen und eine Porenmatrix (PM) vorhanden ist.

8. Wärmetauscheranordnung (1) nach einem der Ansprüche 1 bis 7, wobei eine Porengröße (PG) im Bereich von 0,2 mm bis 2.0 mm liegt.

9. Wärmetauscheranordnung (1) nach einem der Ansprüche 1 bis 8, ausgestaltet zur Integration in eine Rückwand eines Schaltschranks (2).

10. Wärmetauscheranordnung (1) nach einem der Ansprüche 1 bis 9, mit einer umlaufenden Nut (N) für eine Dichtung.
